# EUROPÄISCHE PATENTSCHRIFT

(11) **EP 0 698 232 B1**
(45) Veröffentlichungstag und Bekanntmachung des Hinweises auf die Patenterteilung: **14.10.1998**
(21) Anmeldenummer: 94913198.1
(22) Anmeldetag: 10.05.1994
(51) Int. Cl.: G03F 7/16

(54) **VERFAHREN UND VORRICHTUNG ZUM BESCHICHTEN VON LEITERPLATTEN**
PROCESS AND DEVICE FOR COATING PRINTED CIRCUIT BOARDS
PROCEDE ET DISPOSITIF DE REVETEMENT DE PLAQUETTES DE CIRCUITS IMPRIMES

(30) Priorität: 12.05.1993 DE 4315774; 22.07.1993 DE 4324585; 03.09.1993 DE 4329730; 03.09.1993 DE 4329731; 08.11.1993 DE 4337907; 24.01.1994 DE 4401778
(43) Veröffentlichungstag der Anmeldung: 28.02.1996
(73) Patentinhaber: Ciba Specialty Chemicals Holding Inc., 4057 Basel (CH)
(72) Erfinder: SCHÄFER, Hans-Jürgen, D-41749 Viersen (DE)
(74) Vertreter: Zumstein, Fritz, Dr.
(86) Internationale Anmeldenummer: IB9400101
(87) Internationale Veröffentlichungsnummer: WO9427189

(56) Entgegenhaltungen:
- EP-A- 0 362 641
- EP-A- 0 442 196
- DE-U- 9 201 546
- ELECTRONIC PACKAGING AND PRODUCTION, Bd.33, Nr.9, September 1993, MASSACHUSETTS US Seiten 78 - 81 SUSAN CRUM 'Advances in Liquid Photoimageable Solder Mask Technology'

## Beschreibung

Die Erfindung betrifft ein Verfahren zum Beschichten von Leiterplatten mit einer durch elektromagnetische Strahlung, vorzugsweise UV-Strahlung, vernetzbaren Beschichtung gemäss Oberbegriff des Patentanspruchs 1. Die Erfindung betrifft auch eine dazu geeignete Vorrichtung gemäss Oberbegriff des Patentanspruchs 12 sowie die Verwendung des Verfahrens für verschiedene Applikationszwecke.

Die Leiterplatte hat die Funktion, die leitende Verbindung zu den Bauelementen herzustellen. Mit der fortschreitenden Miniaturisierung wird die Zahlen der Anschlüsse immer grösser, sodass die Leiterplattentechnologie nicht nur die Mehrebenenschaltung hervorgebracht hat sondern die Leiterzüge immer schmaler, die Bohrlochdurchmesser immer kleiner und die Anzahl von Leiterzügen zwischen zwei Bohrungen immer grösser werden.

Mit der Entwicklung der oberflächenmontierten Bauteile (surface mounted devices) konnte eine weitere Reduzierung der erforderlichen Fläche erreicht werden. Dies führte zu Leiterbreiten von kleiner 100 µm, zu Bohrlochdurchmessern von 0.3-0.2 mm und zu Lötaugendurchmessern von nur noch bis zu 0.4 mm bei bis zu sieben Leiterzügen zwischen einem Bohlochraster von 2.54 mm. Gleichzeitig müssen immer mehr Anschlüsse pro integrierter Schaltung realisiert werden, was zu Rastern der Anschlusspads von 0.3-0.4 mm führt. Die aus der immer höheren Integrationsdichte resultierenden Probleme sind sehr komplex und erfordern eine umfassende Lösung. Sie beginnen zunächst bei der Leiterbilderzeugung.

Zur Herstellung eines Leiterbildes wird das gebohrte kupferkaschierte Basismaterial mit einem Resist beschichtet. Während dies früher siebdruckfähige Aetz- oder Galvanoresiste waren, so werden heute überwiegend Fotoresiste eingesetzt. Hierbei handelt es sich um Fest- bzw. Flüssigresiste. Diese werden entweder auf die Oberfläche auflaminiert (Festresiste) oder mit einer Giessmaschine bzw. mit Walzen aufgetragen (Flüssigresiste).

Das Leiterbild wird nach dem Auflegen einer Maske beispielsweise durch Belichtung mit UV-Licht unter Polymerisation des Resistes fixiert und freientwickelt. Dies führt zu dem sogenannten Patternplating-Prozess. Beim Patternplating wird zunächst eine Maske aufgelegt und werden nur die leiterfreien Bereiche belichtet und entwickelt. Danach werden die Leiterzüge galvanisch aufgebaut und die gebohrten Kontaktierlöcher verkupfert. Nach der galvanischen Abscheidung der Leiter werden diese beispielsweise mit einer Zinnauflage versehen, der Galvanoresist wird enfernt und das Leiterbild geätzt. Da die Aetzgeschwindigkeit in allen Richtungen gleich ist, entspricht die Unterätzung etwa der Dicke der verwendeten Kupferfolie. Die im Ätzschritt des Patternplating-Prozesses auftretende Unterätzung stellt die Grenze für die grosstechnische Anwendung dieses Verfahrens dar. Ausserdem ist bedingt durch die Bad- bzw. Leiterplattengeometrie die Herstellung von Leitern gleicher Höhe oft nicht möglich.

Für die Feinstleitertechnologie wurde daher das sogenannte Panelplatingverfahren entwickelt. Hierbei geht man von dem gebohrten, kupferkaschierten Basismaterial aus und verkupfert zuerst galvanisch die Leiterplattenfläche und die gebohrten Löcher, um eine gleichmässige Dicke der Kupferschicht zu erreichen. Anschliessend wird ein Trockenfilmresist auflaminiert, mit einer Maske belichtet und entwickelt.

Bei Feinstleitern kommt es jedoch häufig zu Einschnürungen, weil der Liniendruck der Laminierwalze Unebenheiten des Basismaterials nicht ausgleichen kann, sodass die Haftung des Trockenfilmresistes nicht überall gleich gross ist. Besonders wichtig ist es, dass auch die bereits verkupferten Bohrlöcher vor dem Aetzangriff geschützt werden. Dies geschieht durch das Ueberdecken der Bohrungen mit Resist, dem sogenannten "Tenten".

Die weitere Miniaturisierung und die Technologie der oberflächenmontierten Bauelemente führte zu sogenannten restringfreien Durchsteigerbohrungen. Hier kann die Technologie der Trockenfilmlaminierung nicht angewandt werden, da der Resistfilm ohne die sogenannten Restrings nicht mehr auf der Leiterplattenoberfläche befestigt werden kann. Um jedoch auch restringfreie Bohrungen mit Resist bedecken zu können und sie derart vor dem Ätzangriff zu schützen, wurde die sogenannte Elektrotauchlackierung gefunden, welche aus einem Lackierbad einen 5-15 µm dicken Resistfilm in Loch und auf der Leiterplattenoberfläche abscheidet. Dieses Verfahren ist jedoch sehr kostenintensiv und kann auf Grund der geringen Schichtdicke nur zusammen mit dem Panelplatingverfahren eingesetzt werden.

Eine weitere Problematik der Feinstleiter und "fine pitch" Technologie besteht in der hohen Anschlussdiche der Bauelemente und des damit verbundenen Anschlussrasters von derzeit bis zu nur 0.3 mm. Hier macht sich insbesondere die runde Oberfläche des auf die Anschlusspads im Heissverzinnungsprozess aufgetragenen Lots negativ bemerkbar. Die Bauelemente rutschen auf der runden Oberfläche des Lots oft weg. Zur Abhilfe wird in der DE-A-41 37 045 vorgeschlagen, eine Lotpastenfolie ganzfläching auf die mit leitenden Bereichen versehene Leiterplatte aufzulaminieren, mit einer Positivmaske im UV-Licht zu belichten und die Anschlussstellen, die Pads freizuentwickeln. In diese Resistaussparungen wird mit einer Rakel Lotpaste eingefüllt. Die eingefüllte Lotpaste wird zu Lotdepots umgeschmolzen. Danach wird die restliche Lotpastenfolie wieder entfernt. Schliesslich wird die Leiterplatte mit den Bauelementen bestückt und diese im Reflow-Lötverfahren gelötet. Dieses Verfahren eignet sich für kleine Losgrössen. Bei industriellen Grossserien ist es jedoch unwirtschaftlich und führt zu deutlichen Mehrkosten pro qm Leiterplatte. Ausserdem kann es bei der Beschichtung der Leiterplatten mit der trockenen Lotpastenfolie zu Lufteinschlüssen zwischen den Leiterzügen kommen.

Der vorliegenden Erfindung liegt die Aufgabe zu Grunde, ein Verfahren und eine Vorrichtung verfügbar zu machen, mit denen es möglich ist, mit fotopolymerisierbaren Positiv- und Negativresisten Beschichtungen von unterschiedlicher Dicke zu erstellen, klebfreie im Kontakt belichtbare Aetz-, Galvano-, Permanent- und Lötstoppmasken sowie Masken für die Erstellung von hohen Lötdepots herzustellen und restringfreie Bohrungen sicher zu verschliessen. Des weiteren liegt der Erfindung die Aufgabe zu Grunde, ein einheitliches Verfahren verfügbar zu machen, mit dem es möglich ist, die Anforderungen, die von der Feinstleitertechnologie an die Qualität der Beschichtungen gestellt werden, zu erfüllen. Dabei soll ein wirtschaftliches und technologisch variables Verfahren verfügbar gemacht werden, welches die Vielzahl der bekannten, auf unterschiedlichen physikalischen Prinzipien beruhenden Verfahren ersetzen kann. Es soll auch eine Vorrichtung geschaffen werden, welche es erlaubt, das erfindungsgemässe Verfahren möglichst kostengünstig und in qualitativ hochstehender Weise durchzuführen.

Die Lösung dieser und noch weiterer damit zusammenhängender Aufgaben erfolgt durch ein Verfahren zum Beschichten von Leiterplatten mit einer durch elektromagnetische Strahlung, vorzugsweise UV-Strahlung, vernetzbaren Beschichtung gemäss Kennzeichen des Patentanspruchs 1 sowie durch eine dafür geeignete Vorrichtung gemäss Oberbegriff des Patentanspruchs 12. Insbesondere weist das erfindungsgemässe Verfahren zum

Beschichten von Leiterplatten die folgenden Verfahrensschritte auf:
- die Leiterplatten werden beschichtungsseitig auf Raumtemperatur gehalten und gegebenenfalls bis auf etwa 120°C erwärmt; dann
- wird in einem ersten Schritt ein vorzugsweise fotopolymerisierbares, bei Raumtemperatur hochviskoses bis festes, schmelzbares, niedermolekulares Beschichtungsmittel mit einem mittleren Molekulargewicht von etwa 500-1500 in einer Dicke von etwa 10 µm-200 µm auf die zu beschichtende(n) Oberfläche(n) der Leiterplatte aufgetragen;
- in einem zweiten Schritt wird über diese erste Schicht ein zweites, hochmolekulares, fotopolymerisierbares Beschichtungsmittel mit einem mittleren Molekulargewicht von etwa 2'000-10'000 in einer Dicke von 2 µm-20 µm aufgebracht; und
- die derart beschichteten Leiterplatten werden auf Raumtemperatur abgekühlt und die zweilagige fotopolymerisierbare Beschichtung vorzugsweise im Kontakt mit einer Maske belichtet, entwickelt und ausgehärtet.

Das erfindungsgemässe zweistufige Beschichtungsverfahren mit einem niedermolekularen, bei Raumtemperatur hochviskosen bis festen, schmelzbaren Beschichtungsmittel im ersten Schritt unc mit einem hochmolekularen Beschichtungsmittel im zweiten Schritt erlaubt die Erstellung von Beschichtungen auf Leiterplatten, deren Oberfläche klebfrei ist, sodass die Leiterplatten problemlos weiter gehandhabt werden können, und insbesondere eine Belichtung mit Masken im Kontaktverfahren ermöglicht ist. Das zweistufige Beschichtungsverfahren ist universell einsetzbar beispielsweise können auf diese Weise auf wirtschaftliche Weise Lötstoppmasken, Ätz- bzw. Galvanoresists oder auch Permanentresists für Additivverfahren und Masken für die Herstellung von hohen Lötdepots erstellt werden. Die erste Teilschicht der Beschichtung muss nicht notwendigerweise klebfrei sein, da im zweiten Schritt ein hochmolekulare Schicht aufgebracht wird, bei der Klebfreiheit gewährleistet ist. Der erste Beschichtungsschritt kann mit lösungsmittelhaltigen Flüssigresists durchgeführt werden, vorzugsweise werden aber lösungsmittelarme bis lösungsmittelfreie Beschichtungsmittel verwendet. Insbesondere ist das erste Beschichtungsmittel bei Raumtemperatur hochviskos bis fest, lässt sich aber bei erhöhten Temperaturen schmelzen, ohne dabei jedoch chemische Bindungen zu zerstören. Die erste Beschichtung kann im Vorhanggiessverfahren oder auch im Walzenbeschichtungsverfahren aufgetragen werden.

Die hochmolekulare zweite Teilschicht kann auf verschiedene Weise aufgetragen werden. Insbesondere aber wird die zweite Schicht im Vorhangguss, durch Walzenbeschichtung, durch Aufsprühen, durch Auflaminieren oder im Siebdruck aufgetragen. Nach dem Auftragen der zweite Teilschicht liegt eine Gesamt-Beschichtung vor, deren Oberfläche klebfrei ist, welche die erforderliche Dicke aufweist, und welche in der üblichen Weise weiterverarbeitet werden kann.

Die erfindungsgemässe Vorrichtung zum Auftragen einer durch elektromagnetische Strahlung, vorzugsweise UV-Strahlung, vernetzbaren Beschichtung auf die Oberfläche(n) von Leiterplatten weist eine Reihe von Bearbeitungsstationen für die Leiterplatten auf, welche entlang einer Transportbahn für die Leiterplatten angeordnet sind. Sie umfasst wenigstens eine Beschichtungsstation zum Auftragen der Beschichtung auf die Leiterplattenoberfläche(n) und eine Einrichtung zum Temperieren der Leiterplattenoberfläche(n) auf eine Temperatur vorzugsweise grösser oder gleich Raumtemperatur. Insbesondere sind eine erste Beschichtungsstation und eine zweite Beschichtungsstation vorgesehen, wobei die erste zum ein- oder beidseitigen Auftragen eines vorzugsweise fotopolymerisierbaren, bei Raumtemperatur hochviskosen, schmelzbaren, niedermolekularen ersten Beschichtungsmittels mit einem mittleren Molekulargewicht von etwa 500-1500 ausgebildet ist, und die zweite Beschichtungsstation zum Auftragen eines hochmolekularen, vorzugsweise fotopolymerisierbaren, zweiten Beschichtungsmittels mit einem Molekulargewicht von etwa 2'000-10'000 über die erste Beschichtung ausgerüstet ist. Die Temperiereinrichtung für die Leiterplattenoberfläche(n) ist vor der ersten Beschichtungsstation angeordnet bzw. ist Bestandteil dieser Beschichtungsstation.

Bevorzugte Varianten des erfindungsgemässen Verfahrens und der dazu ausgebildeten Vorrichtung sowie diverse Applikationsmöglichkeiten sind Gegenstand der jeweiligen abhängigen Verfahrens-bzw. Vorrichtungs- bzw. Verwendungsansprüche. Die Vorteile der Varianten ergeben sich aus der Beschreibung in Verbindung mit den schematischen Zeichnungen.

Im folgenden wird die Erfindung mit den ihr als wesentlich zugehörigen Einzelheiten unter Bezugnahme auf die Zeichnungen näher erläutert. Es zeigen:
- Fig. 1: eine schematische Darstellung einer erfindungsgemässen Gesamtanlage zur zweistufigen Beschichtung von Leiterplatten,
- Fig. 2: eine erste Variante einer Vorhanggiess-Beschichtungsanlage,
- Fig. 3: eine zweite Variante einer Vorhanggiess-Beschichtungsanlage, und
- Fig. 4: eine Walzenbeschichtungsanlage.

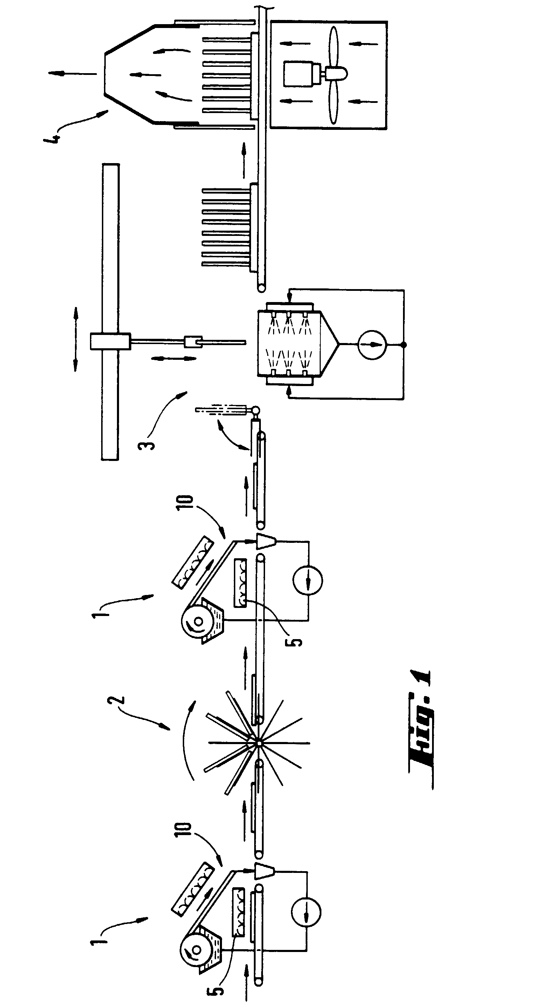

Die in Fig. 1 schematisch dargestellte Beschichtungsanlage für Leiterplatten umfasst eine erste Beschichtungsstation 1 zum Auftragen eines ersten Beschichtungsmittels und eine zweite Beschichtungsstation 3 zum Beschichten mit dem zweiten Beschichtungsmittel. Die erste Beschichtungsstation 1 umfasst beispielsweise zwei identisch ausgebildete Vorhanggiessanlagen 10 zwischen denen eine Wendestation 2 zum Wenden der Leiterplatten angeordnet ist. Die zweite Beschichtungsstation 3 ist beispielsweise eine Sprühbeschichtungsstation, in der die Leiterplatten gleichzeitig auf beiden Seiten mit dem zweiten Beschichtungsmittel besprüht werden. Im Anschluss an die zweite Beschichtungsstation 3 ist eine Trockeneinrichtung 4 vorgesehen, in der die zweilagig beschichteten Leiterplatten klebfrei getrocknet werden.

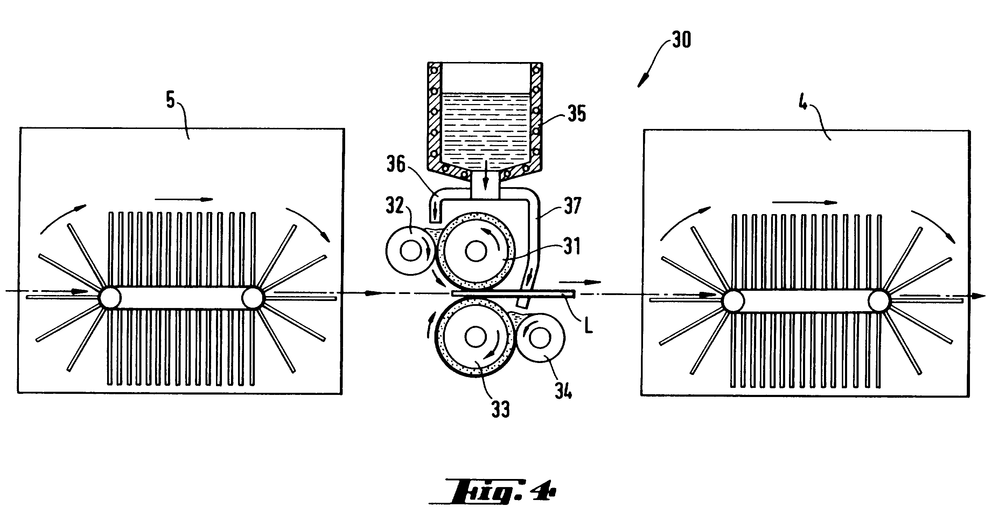

Die dargestellte Beschichtungsanlage ist üblicherweise Bestandteil einer grösseren Leiterplattenverarbeitungsanlage. So können vor der ersten Beschichtungsstation 1 beispielsweise Bohrstationen zum Erstellen von Bohrungen in den Leiterplatten, mechanische und/oder chemische Reinigungsstationen zum Reinigen der zu beschichtenden Oberflächen oder auch Galvaniesierstationen vorgesehen sein. Hinter der zweiten Beschichtungsstation 3 bzw. der Trockeneinrichtung 4 sind beispielsweise Belichtungsstationen angeordnet, in denen die aufgetragene zweilagige Beschichtung vorzugsweise mit UV-Strahlung belichtet wird. Im Anschluss daran können beispielsweise Ätzstationen angeordnet sein, in denen die belichtete Beschichtung in der gewünschten Weise strukturiert wird, um dann in weiteren Stationen die Leiterplatten weiterzubehandeln. Vor der Beschichtung der Leiterplattenoberflächen mit dem ersten Beschichtungsmittel werden sie in einer Temperiereinrichtung 5 auf Raumtemperatur stabilisiert bzw. auf eine Temperatur bis etwa 120°C erwärmt. Diese Temperiereinrichtung 5 ist entweder als separate Einheit ausgebildet und unmittelbar vor der ersten Beschichtungsstation angeordnet, wie beispielsweise bei einer Walzenbeschichtungsanlage (Fig. 4) oder sie ist Bestandteil der Vorhanggiessanlage, wie beispielsweise in den Fig. 1-3 angedeutet ist.

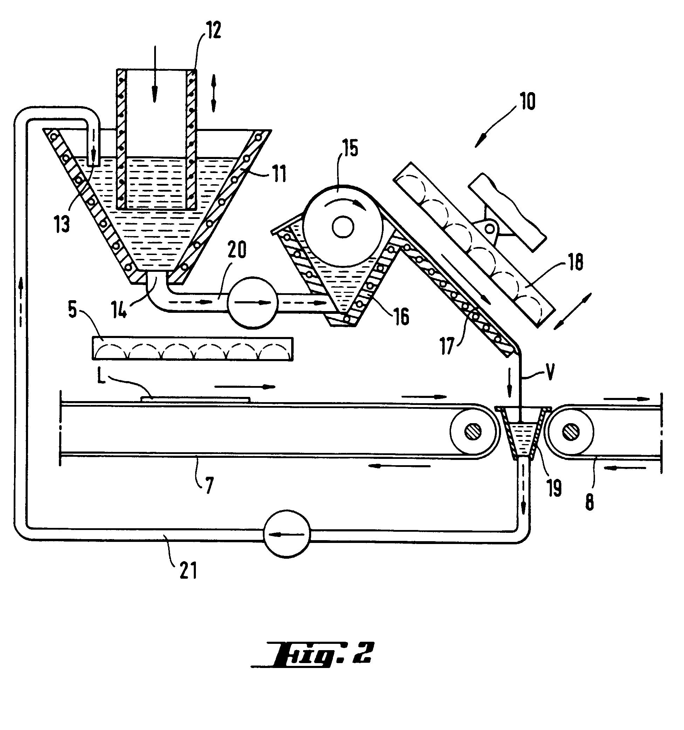

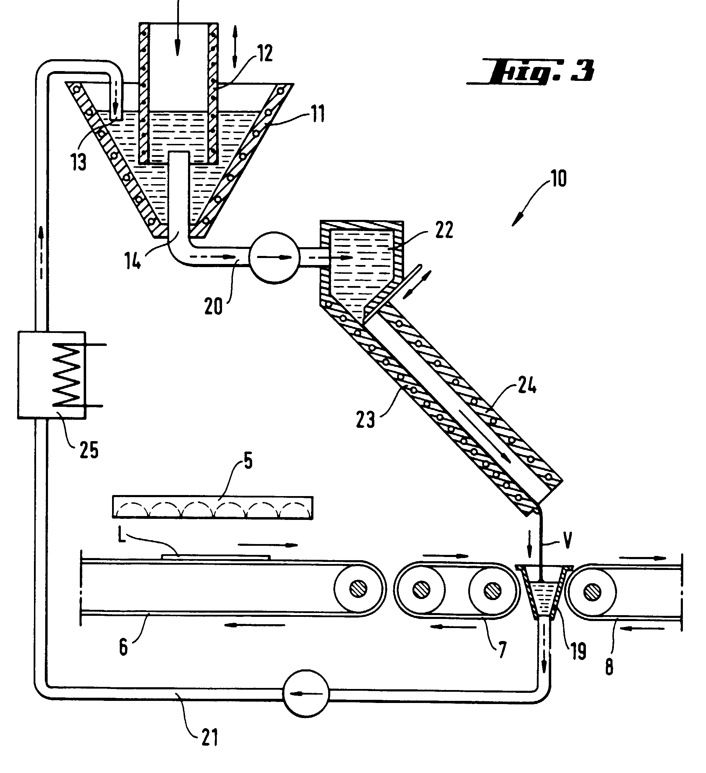

In den Fig. 2 und 3 sind zwei bevorzugte Ausführungsvarianten von Vorhanggiessanlagen im Prinzip dargestellt, die speziell für die Applikation eines fotopolymerisierbaren Beschichtungsmittels ausgebildet sind, welches bei Raumtemperatur hochviskos bis fest ist und bei erhöhter Temperatur schmelzbar ist, und das vorzugsweise ein mittleres Molekulargewicht von 500-1500 aufweist. Die beispielsweise dargestellte Vorhanggiessanlagen 10 weisen einen beheizbaren Vorratstank 11,12 für das erste Beschichtungsmittel auf, der über eine thermisch isolierte bzw. gegebenenfalls beheizbare Verbindungleitung 20 mit einer Dosiereinrichtung 15,16 bzw. 22 verbunden ist. Mit der Dosiereinrichtung wird das erste Beschichtungsmittel auf eine beheizbare Rakel 17 oder ein beheizbares Ablaufblech 23 oder ähnliches aufgetragen, welche(s) von der Dosiereinrichtung 15,16 bzw. 22 in Leiterplattentransportrichtung schräg nach unten geneigt verläuft und oberhalb der Transportebene der Leiterplatten L endet. Vorzugsweise beträgt der Neigungswinkel etwa 30°-60°, insbesondere etwa 45°, gegenüber der Horizontalen. Über der Rakel 17 bzw. dem Ablaufblech 23 ist eine Heizeinrichtung 18 oder eine beheizbare Abdeckung 24 angeordnet. Beispielsweise ist die Heizeinrichtung 18, wie in Fig. 2 angedeutet eine Infrarotstrahleranordnung, die schwenkbar aufgehängt ist, um auf diese Weise den Abstand der Infrarotstrahler entlang der Längserstreckung der Rakel 17 bzw. des Ablaufbleches 23 variieren zu können.

Der Giesstisch ist durch zwei Förderbänder 7 und 8 angedeutet, welche zwischen sich einen Spalt freilassen. In diesem Spalt ist unterhalb der Transportebene der Leiterplatten L ein Auffangbehälter 19 für das erste Beschichtungsmittel angeordnet, der über einen wärmeisolierten und/oder heizbaren Rücklauf 21 mit dem Vorratstank 11,12 in Verbindung steht. In den Verbindungsleitungen 20 bzw. im Rücklauf 21 sind Förderpumpen angeordnet, mit denen das erste Beschichtungsmittel umgepumpt wird. Im Rücklauf können auch noch Wärmetauscher 25 vorgesehen sein, um das erste Beschichtungsmittel auf die gewünschte Temperatur einzustellen.

Bei der Dosiereinrichtung handelt es sich im Fall von Fig. 2 beispielsweise um eine beheizbare, im Querschnitt etwa V-förmige Wanne 16, in der eine ebenfalls beheizbare Auftragswalze 15 rotiert. Diese Auftragswalze nimmt das verflüssigte erste Beschichtungsmittel auf und streift es auf die Rakel 17 ab. Die Dosiereinrichtung gemäss Fig. 3 ist konventioneller Schlitzgiesser 22 mit verstellbaren Giesslippen. Vom Schlitzgiesser 22 ergiesst sich das flüssige erste Beschichtungmittel auf das beheizbare Ablaufblech 23.

Der Vorratstank ist in zwei Kammern, eine äussere 11 und eine innere Kammer 12 aufgeteilt, die in der Nähe des Behälterbodens miteinander kommunizieren. Die Kammern sind, wie in den Fig. 2 und 3 dargestellt, vorzugsweise konzentrisch angeordnet. Der Rücklauf 21 für das erste Beschichtungsmittel mündet an der Einlassöffnung 13 in die äussere Kammer 11, die beheizbar ist. Die innere Kammer 12 weist vorzugsweise an der tiefsten Stelle ihres Bodens, einen Auslass 14 für das flüssige erste Beschichtungsmittel auf. Der Auslass 14 der inneren Kammer 12 ist tiefer angeordnet ist als die Mündung 13 der Rücklaufleitung 21 in die äussere Kammer 11 und ist im Betrieb vollständig von dem geschmolzenen ersten Beschichtungsmittel bedeckt. Die spezielle Ausbildung des Vorratstanks mit zwei Kammern 11,12 erlaubt ein luftblasenfreies Absaugen des ersten Beschichtungsmittels durch die an der tiefsten Stelle des Behälterbodens angeordnete Auslassöffnung 14.

Das bei Raumtemperatur hochviskose bis feste, schmelzbare erste Beschichtungsmittel wird vorzugsweise in in einem Wärmeschrank vorgewärmt und bei einer Viskosität von etwa 5000-10'000 mPas in den beheizbaren Vorratstank 11,12 gefüllt. Im Vorratstank wird das erste Beschichtungsmittel auf etwa 60°C erwärmt und durch die thermisch isolierte und/oder beheizbare Verbindungsleitung 20 der Dosiereinrichtung 15,16 bzw. 17 zugeführt. Von dort wird das erste Beschichtungsmittel mit einer Temperatur von etwa 60°C und einer Viskosität von etwa 1000-5000 mPas auf die Rakel 17 abgestreift bzw. auf das schräge Ablaufblech 23 gegossen. Durch die Neigung der Rakel 17 bzw. des Ablaufbleches 23 fliesst das erste Beschichtungsmittel nach unten. Während des Abfliessens über die Rakel 17 bzw. das Ablaufblech 23, welche etwa 20-50 cm lang sind, wird das erste Beschichtungsmittel auf Giesstemperatur und Giessviskosität gebracht. Dies erfolgt durch die oberhalb des Rakels bzw. des Ablaufblechs angeordnete Heizeinrichtung, die entweder eine Infrarotstrahleranordnung 18 ist (Fig. 2) oder durch eine im Abstand von vorzugsweise etwa 10 mm über der Rakel oder dem Ablaufblech angeordnete beheizbare Abdeckung 24 gebildet ist (Fig. 3). Dadurch wird das erste Beschichtungsmittel auf eine Giesstemperatur von etwa 60°C-120°C erwärmt. Seine Viskosität beim Giessen beträgt etwa 100-500 mPas. Die Leiterplattem L werden unter dem sich bildenden frei fallenden Giessvorhang V mit einer Geschwindigkeit von beispielsweise etwa 100-200 m/min hindurchbewegt und dabei in einer Dicke von etwa 30-200 µm mit dem ersten Beschichtungsmittel, das ein mittleres Molekulargewicht von etwa 500-1500 aufweist, beschichtet. Vor dem Transport der Leiterplatten unter dem Vorhang hindurch wird deren zu beschichtende Oberfläche in der Temperiereinrichtung 5 auf die erforderliche Temperatur gebracht. Dies kann beispielsweise eine Stabilisierung auf Raumtemperatur sein, es kann aber auch gewünscht sein, die Temperatur der Leiterplattenoberfläche auf bis zu etwa 120°C zu erwärmen. Dies erfolgt beispielsweise durch eine Infrarotstrahleranordnung, die oberhalb des ersten Transportbandes 7 des Giesstisches bzw. oberhalb eines Vorbeschleunigerbandes 6 angeordnet ist.

Dadurch dass das erste niedermolekulare Beschichtungsmittel erst unmittelbar vor der Beschichtung auf die erforderliche Giesstemperatur und die erforderliche Giessviskosität gebracht wird, ist gewährleistet, dass einerseits keine chemischen Bindungen durch allzulange thermische Beanspruchung degradieren, andererseits wird dadurch auch sichergestellt, dass die Polymerisationsreaktion im ersten Beschichtungsmittel nicht schon unbeabsichtigt vor der Beschichtung ausgelöst wird. Das als Vorhang V abfliessende erste Beschichtungmittel wird in einem Auffangbehälter 19 gesammelt und über den Rücklauf 21 wieder zu dem Vorratstank 11,12 zurückgepumpt. Im Rücklauf 21 kann noch ein Wärmetauscher 25 vorgesehen sein, mit dem das erste Beschichtungsmittel wieder auf Temperatur eingestellt werden kann, die der gewünschten Temperatur im Vorratstank des ersten Beschichtungsmittels im Vorratstank 11,12 entspricht.

Nachdem auf diese Weise die erste Seite der Leiterplatte L beschichtet worden ist kann sie entweder sofort zur zweiten Beschichtungsstation 3 weitertransportiert werden, oder aber sie wird in einer Wendestation 2 gewendet, um sie zunächst in einer identischen Vorhanggiessanlage auch auf der zweiten Seite mit dem ersten niedermolekularen Beschichtungsmittel zu beschichten.

In einer alternativen Variante des erfindungsgemässen Verfahrens erfolgt die erste Beschichtung der Leiterplatte in in einer Walzenbeschichtungsanlage. Je nach der gewünschten Beschichtungsart, einseitig oder beidseitig, kann es sich dabei um eine einzelne Walzenbeschichtungsanlage für einseitige Beschichtung handeln, oder es können zwei einseitige Walzenbeschichtungsanlagen hintereinandergeschaltet werden. Wie im Fall der Vorhanggiessanlagen ist dann zwischen den Anlagen eine Wendestation angeordnet. Vorzugsweise wird für die beidseitige Beschichtung von Leiterplatten jedoch eine doppelseitige Walzenbeschichtungsanlage 30 eingesetzt, wie sie beispielsweise in Fig. 4 dargestellt ist. Bei der dargestellten Anlage handelt es sich insbesondere um eine doppelseitige Walzenbeschichtungsanlage 30, welche für die gleichzeitige beidseitige Beschichtung der Leiterplatten ausgerüstet ist und über zwei beheizbare Auftragwalzen 31,33 verfügen. Die Auftragfläche der Auftragwalzen 31,33 ist vorzugsweise gummiert. Unmittelbar benachbart zu jeder Auftragswalze 31,33 ist eine gleichfalls beheizbare Dosierwalze 32,34 angeordnet. Dabei sind die Dosierwalzen derart angeordnet, dass jeweils zwischen der Dosierwalze 32,34 und der Auftragwalze ein schmaler Spalt freibleibt. Die Spaltweite definiert die dicke des Films aus erstem Beschichtungsmittel, der sich auf der Auftragwalze 31,33 bildet. Zur Versorgung mit erstem Beschichtungsmittel ist vorzugsweise oberhalb der Auftragswalzen 31,33 ein beheizbarer Vorratsbehälter 35 für das Beschichtungsmittel vorgesehen, von dem thermisch isolierte bzw. heizbare Versorgungsleitungen 36,37 zu den jeweiligen Walzenpaaren 31,32 bzw. 33,34 führen. Die obere und die untere Auftragwalze 31,33 sind vorzugsweise einen Abstand voneinander entfernt, der etwa 50%-95% der Leiterplattendicke entspricht.

Die Dosierspalte zwischen den auf 60°C-90°C beheizten gummierten Auftragswalzen 31,33 und den auf 70 bis 110°C aufgeheizten Dosierwalzen 32,34 wird derart eingestellt, dass zwischen ihnen eine Lackwanne entsteht. Das bei Raumtemperatur hochviskose bis feste erste Beschichtungsmittel wird im Vorratsbehälter 35 soweit verflüssigt, dass es den beiden Walzenpaaren 31,32 bzw. 33,34 zugeführt werden kann. Zur Beschichtung werden die Leiterplatten L mit einer Geschwindigkeit von etwa 5-20 m/min durch den Durchtrittsspalt zwischen den beiden Auftragwalzen 31,33 hindurchtransportiert. Dadurch dass die Auftragwalzen und die Dosierwalzen beheizbar sind, kann das erste Beschichtungsmittel erst unmittelbar vor dem Auftrag auf die Leiterplattenoberfläche auf die erforderliche Auftragtemperatur und die erforderliche Auftragviskosität gebracht werden. Vor der Beschichtung werden die Leiterplatten L in einer vor der Walzenbeschichtungsanlage 30 angeordneten Temperiereinrichtung auf die gewünschte Beschichtungstemperatur gebracht.

In einer bevorzugten Verfahrensvariante werden die Leiterplatten L vor der Beschichtung in der Temperiereinrichtung 5 aufgeheizt, so dass ihre Oberfläche eine höhere Temperatur aufweist als das aufgetragene Beschichtungsmittel. Auf diese Weise wird erreicht, dass das erste Beschichtungsmittel auf der Leiterplattenoberfläche noch weiter verflüssigt wird, um Unebenheiten besser auszugleichen. Die Auftragsviskosität des ersten Beschichtungsmittels bei dieser bevorzugten Verfahrensvariante beträgt dabei etwa 1000-20'000 mPas, vorzugsweise etwa 8000-12'000 mPas. Die aufgetragene Schichtdicke beträgt etwa 30-200 µm.

Die der Walzenbeschichtungsanlage nachgeschalte Trockeneinrichtung 4 ist beispielsweise als Luftkühler ausgebildet, in dem die beschichteten Leiterplatten L auf Raumtemperatur abgekühlt werden.

Nach dem Auftragen des ersten Beschichtungsmittels werden die Leiterplatten L zu der zweiten Beschichtungsanlage 3 transportiert, in der die zweite Beschichtung mit hohem Molekulargewicht von etwa 2000-10'000 über die erste aufgetragen wird. Die zweite Beschichtungsanlage 3 kann eine Walzenbeschichtungsanlage, eine Sprühbeschichtungsanlage, eine Siebdruck-Beschichtungsstation, eine Laminierstation oder eine Vorhanggussbeschichtungsanlage zum ein- oder beidseitigen Auftragen des zweiten Beschichtungsmittels sein. Danach wird die zweilagige Schicht getrocknet. Infolge des hohen Molekulargewichts des zweiten Beschichtungsmittels ist gewährleistet, dass die erzielte Oberfläche nach dem Trocknen klebfrei ist.

Je nach Wahl der Beschichtungsmittel eignet sich die zweilagige Beschichtung für unterschiedliche Anwendungen. Es hat sich gezeigt, dass die Wirtschaftlichkeitsbetrachtung bei der Feinstleitertechnologie nicht primär an den Rohstoff-, Personal- und Investitionskosten ausgerichtet werden kann, sondern dass die Ausschussrate bzw. die Ausbeute die entscheidende Wirtschaftlichkeitsgrösse darstellt. Dies zeigt sich um so dringlicher, je höher der Verarbeitungsgrad ist. Daher sind Lötfehler an mit hochwertigen Bauelementen bestückten Platinen von entscheidender Bedeutung. Mit der Verwendung von Festoff-armen Fluxmitteln und dem Wegfall der Reinigung haben sich Probleme bei der Lötung eingestellt. Es kommt beim Wellenlöten zur Bildung von Lotperlen, die besonders an glatten Oberflächen anhaften und zu Kurzschlüssen führen können. Da diese Erscheinung bevorzugt auf Lötmaskenoberflächen auftritt, jedoch nicht bei Basismaterial, hat man die Ursache in der durch das Treatment der Kupferfolie nach dem Aetzen erzeugten rauhen Oberfläche des Basismaterials gesehen. Entsprechende Aufrauhversuche der Lötstoppmaske chemisch und mechanisch brachten zwar Erfolge, jedoch beeinträchtigen sie die Beschichtung in ihren Isolationseigenschaften und der elektrolytischen Korrosion.

Um diesem Problem abzuhelfen werden dem zweiten Beschichtungmittel Füllstoffe beigefügt, die eine relativ grosse Korngrösse aufweisen. Vorzugsweise beträgt der Anteil an Füllstoffen im zweiten Beschichtungsmittel etwa 20-70 Gew.-%. Die mittlere Korngrösse der Füllstoffe beträgt dabei etwa 5-20 µm. Auf diese Weise wird eine Oberfläche mit definierter Rauhigkeit erhalten, die eine Anhaftung von Lötperlen beim Lötprozess verhindert.

Die zweilagige Beschichtung kann aber auch einen Ätz- bzw. Galvanoresist ergeben, der nach der entsprechenden Behandlung der Leiterplatten wieder entfernt wird. Sie kann aber auch einen zweilagigen Permanentresist für Additivverfahren ergeben oder als Mske für die Erstellung von hohen Lötdepots eingesetzt werden.

Im folgenden werden Beispiele für unterschiedliche zweilagige Beschichtungen erläutert. In den Beispielen werden zur Herstellung der Beschichtungsmittel folgende Harzkomponenten eingesetzt:

Harzkomponente A: Mittels Strahlen vernetzbares und thermisch härtbares Harz, welches bei Raumtemperatur eine Viskosität von 200000 mPa·s und bei 100°C eine Viskosität von 200 mPa·s aufweist. Dieses Harz wird erhalten, indem man 1 Mol eines Kresolnovolaktriglycidylethers mit einem Molekulargewicht von 580 mit 1 Mol Acrylsäure umsetzt und anschliessend das erhaltenen Umsetzungsprodukt während 3 Stunden bei 60°C mit einem ungesättigten Isocyanatocarbamatester mit einem Molekulargewicht von 290 umsetzt, der durch Umsetzung von 1 Mol Toluylen-2,4- und -2,6-diisocyanat-Isomerengemisch mit 1 Mol Hydroxyethylacrylat gemäss EP-A-0 194 360, Beispiel 2, erhalten wurde.

Harzkomponente B: Zusatzmittel, wie Füllstoffe, Verlaufsmittel und
Härtungsbeschleuniger, enthaltender Phenolnovolak mit einem Molekulargewicht von 250 der folgenden Zusammensetzung:
30 Gewichtsteile Phenolnovolak,
30 Gewichtsteile Microtalkum,
30 Gewichtsteile Aluminiumoxidtrihydrat,
6 Gewichtsteile Ethylanthrachinon,
3 Gewichtsteile 2-Methylimidazol und
1 Gewichtsteil Verlaufsmittel Byk® 361.

Harzkomponente C: 50%-ige Lösung eines lichtempfindlichen Epoxidharzes aus Bis-1,3-(4-glycidyloxybenzal)-aceton, Bisphenol A und Tetrabrombipshenol A mit einem Molekulargewicht von 3000-3500, hergestellt gemäss Beispiel 1 des EP-Patentes 0 075 537.

### Beispiel 1:

In einem zweistufigen Beschichtungsverfahren wird eine Lötstoppmaske mit lötperlenabweisender Oberfläche erstellt.

| | | |
|---|---|---|
| Leiterplatte: | Basismaterial FR 4 Dicke | 1.6 mm |
| | Kupferkaschierung: | 17.5 µm |
| | Leiterhöhe: | 50 µm |

### Beschichtungsmittel 1:

59 Gewichtsteile Harzkomponente A und
41 Gewichtsteile Harzkomponente B.

Die Viskosität des ersten Beschichtungsmittels beträgt bei 25°C etwa 200'000 mPas. Das erste Beschichtungsmittel wird im Vorhanggiessverfahren aufgetragen. Die Giesstemperatur beträgt etwa 100°C. Die Giessviskosität beträgt etwa 200 mPas. Die Oberflächentemperatur der Leiterplatte wird auf etwa 30 °C eingestellt. Die Transportgeschwindigkeit der Leiterplatte unter dem Giessvorhang wird auf 150 m/min eingestellt. Die erzielte Schichtdicke der ersten Beschichtungslage beträgt etwa 50 µm.

### Beschichtungsmittel 2:

45 Gewichtsteile Harzkomponente C,
8 Gewichtsteile Aluminiumoxid,
5 Gewichtsteile Talcum,
5 Gewichtsteile Bariumsulfat,
4 Gewichtsteile Calciumcarbonat,
9 Gewichtsteile Magnesiumoxid,
1 Gewichtsteil Phthalocyaningrün und
23 Gewichtsteile Methylglykol.

Das zweite Beschichtungsmittel wird in einer Sprühbeschichtungsanlage in einer Dicke von etwa 5 µm aufgetragen und mit Luft getrocknet.

### Beispiel 2:

Im zweistufigen Beschichtungsverfahren wird eine Lötstoppbeschichtung in einer Dicke von grösser 100 µm aufgetragen. Die Beschichtung soll soll im weiteren Verfahren zur Bereitstellung von Depotvolumina über fine-pitch IC-Rastern zur Aufnahme von festem Lot bearbeitet werden.

| | | |
|---|---|---|
| Leiterplatte: | Basismaterial FR 4 Dicke | 1.6 mm |
| | Kupferkaschierung: | 17.5 µm |
| | Leiterhöhe: | 65 µm |
| | IC-Raster: | 0.3 mm |

Als erstes Beschichtungsmittel wird das Beschichtungsmittel 1 aus dem Beispiel 1 im Walzenbeschichtungsverfahren aufgetragen. Die Temperatur der Auftragwalze beträgt etwa 70°C. Die Viskosität des ersten Beschichtungsmittels bei 70°C beträgt etwa 1000 mPas. Die Leiterplattenoberfläche weist bei der Beschichtung eine Temperatur von etwa 120°C auf. Die Transportgeschwindigkeit der Leiterplatte bei der Walzenbeschichtung beträgt 8 m/min. Die aufgetragene Schichtdicke beträgt etwa 100 µm.

### zweites Beschichtungsmittel: Harzkomponente C

Das zweite Beschichtungsmittel wird gleichfalls im Walzenbeschichtungsverfahren aufgetragen. Die Viskosität beim Auftrag auf die Leiterplattenoberfläche beträgt etwa 2000 mPas. Die Transportgeschwindigkeit der Leiterplatten bei der Beschichtung beträgt etwa 10 m/min. Die erzielte Schichtdicke beträgt etwa 10 µm. Danach wird die Leiterplatte in senkrechter Stellung in einem Lufttrockner getrocknet. Nachdem sie bei Raumtemperatur klebfrei sind, werden die Leiterplatten unter Auflage einer Maske beidseitig mit UV-Strahlung belichtet und die unbelichteten Bereiche mit einer Entwicklerlösung herausgelöst und die verbleibende Beschichtung ausgehärtet. In die über den IC-Anschlusspads entstandenen Volumina wird Lotpaste eingefüllt und bei etwa 210°C umgeschmolzen.

### Beispiel 3:

Im zweistufigen Beschichtungsverfahren wird ein Galvanoresist aufgetragen, wobei das erste schmelzbare niedermolekulare Beschichtungsmittel im Vorhanggiessverfahren aufgetragen wird und das hochmolekulare zweite Beschichtungsmittel in Form einer Folie als Trockenfilmresist mit Walzen auflaminiert wird.

| | | |
|---|---|---|
| Leiterplatte: | Basismaterial FR 4 Dicke | 1.6 mm |
| | Leiterhöhe: | 65 µm |
| | Bohrlochdurchmesser | 6 mm (maximal) |

erstes Beschichtungsmittel: Phenolnovolak mit einem Molekulargewicht von 500 und einer Viskosität bei 75°C von 20000 mPa·s und bei 120°C von 100 mPa·s.

Die Giesstemperatur des ersten Beschichtungsmittels beträgt etwa 120°C, seine Giessviskosität etwa 100 mPas. Die Leiterplattentemperatur wird auf etwa 80°C eingestellt. Die Transportgeschwindigkeit der Leiterplatten unter dem Vorhang beträgt etwa 170 m/min. Die erzielte Beschichtungsdicke beträgt etwa 50 µm.

### zweites Beschichtungsmittel 5: Trockenfotoresist.

Die beidseitig mit Schmelzresist beschichtete Leiterplatte wird in einem zweiten Beschichtungsvorgang mit einem Trockenfilmfotoresist beschichtet, indem eine 25 µm dicke Folie mit einem Rollenlaminator bei etwa 40°C auflaminiert wird. Anschliessend wird die Leiterplatte unter Auflage einer Maske beidseitig belichtet, und werden die unbelichteten Bereiche herausentwickelt. Die geöffneten Bereiche können dann in gewünschter Weise mit Edelmetallen selektiv metallisiert werden.

## Patentansprüche

1. Verfahren zum Beschichten von Leiterplatten mit einer durch elektromagnetische Strahlung, vorzugsweise UV-Strahlung, vernetzbaren Beschichtung, dadurch gekennzeichnet,
- dass die Leiterplatten beschichtungsseitig auf Raumtemperatur gehalten und gegebenenfalls bis auf etwa 120°C erwärmt werden und dann
- in einem ersten Schritt ein vorzugsweise fotopolymerisierbares, bei Raumtemperatur hochviskoses bis festes, schmelzbares, niedermolekulares Beschichtungsmittel mit einem mittleren Molekulargewicht von etwa 500-1500 in einer Dicke von etwa 10 µm-200 µm auf die zu beschichtende(n) Oberfläche(n) der Leiterplatte aufgetragen wird,
- in einem zweiten Schritt über diese erste Schicht ein zweites, hochmolekulares, fotopolymerisierbares Beschichtungsmittel mit einem mittleren Molekulargewicht von etwa 2'000-10'000 in einer Dicke von 2 µm-20 µm aufgebracht wird und
- die derart beschichteten Leiterplatten auf Raumtemperatur abgekühlt werden und die zweilagige fotopolymerisierbare Beschichtung vorzugsweise im Kontakt mit einer Maske belichtet, entwickelt und ausgehärtet wird.

2. Verfahren nach Anspruch 1, dadurch gekennzeichnet, dass das erste Beschichtungsmittel mit einer Temperatur von etwa 60°C-120°C auf die Leiterplattenoberfläche aufgetragen wird.

3. Verfahren nach Anspruch 1 oder 2, dadurch gekennzeichnet, dass die Leiterplatten vor dem Auftragen des zweiten Beschichtungsmittels beidseitig beschichtet werden.

4. Verfahren nach einem der vorangehenden Ansprüche, dadurch gekennzeichnet, dass das erste Beschichtungsmittel im Vorhangguss aufgetragen wird, wobei seine Giessviskosität beim Auftreffen auf die Leiterplattenoberfläche etwa 100 mPas-500 mPas beträgt.

5. Verfahren nach Anspruch 4, dadurch gekennzeichnet, dass das erste Beschichtungsmittel aus einem Vorratsbehälter auf ein in Transportrichtung der Leiterplatten schräg nach unten geneigtes und kurz oberhalb der Leiterplattentransportebene endendes, vorzugsweise beheizbares Ablaufblech bzw. eine beheizbare Rakel gegossen oder sonstwie aufgebracht wird und durch oberhalb des Giessbleches bzw. der Rakel angeordnete Heizeinrichtungen erst unmittelbar vor dem Auftragen auf die Leiterplattenoberfläche auf Giesstemperatur und Giessviskosität gebracht wird.

6. Verfahren nach einem der Ansprüche 1-3, dadurch gekennzeichnet, dass das erste Beschichtungsmittel im Walzenbeschichtungsverfahren auf die Leiterplattenoberfläche(n) aufgetragen wird.

7. Verfahren nach Anspruch 6, dadurch gekennzeichnet, dass die Auftragungsviskosität des ersten Beschichtungsmittels etwa 1000 mPas-20'000 mPas, vorzugsweise etwa 8'000 mPas-12'000 mPas, beträgt, und dass die zu beschichtende Leiterplattenoberfläche eine höhere Temperatur aufweist als das mit Hilfe der Walzenbeschichtungsanlage aufgetragene erste Beschichtungsmittel.

8. Verfahren nach Anspruch 6 oder 7, dadurch gekennzeichnet, dass das erste Beschichtungsmittel gleichzeitig auf beide Leiterplattenoberflächen aufgetragen wird.

9. Verfahren nach einem der vorangehenden Ansprüche, dadurch gekennzeichnet, dass das zweite hochmolekulare Beschichtungsmittel im Vorhangguss, durch Walzenbeschichtung, durch Aufsprühen, durch Auflaminieren oder im Siebdruck aufgetragen wird.

10. Verfahren nach Anspruch 9, dadurch gekennzeichnet, dass das zweite Beschichtungsmittel einen Anteil von etwa 20-70 Gew.-% Füllstoffe einer mittleren Korngrösse von 5 µm-20 µm enthält.

11. Verfahren nach einem der Ansprüche 9-10, dadurch gekennzeichnet, dass das zweite Beschichtungsmittel auf beide Leiterplattenoberflächen aufgetragen wird, wobei vorzugsweise beide Oberflächen gleichzeitig beschichtet werden.

12. Vorrichtung zum Auftragen einer durch elektromagnetische Strahlung, vorzugsweise UV-Strahlung, vernetzbaren Beschichtung auf die Oberfläche(n) von Leiterplatten, welche entlang einer Transportbahn für die Leiterplatten wenigstens eine Beschichtungsstation zum Auftragen der Beschichtung auf die Leiterplattenoberfläche(n) und eine Einrichtung zum Temperieren der Leiterplattenoberfläche(n) auf eine Temperatur vorzugsweise grösser oder gleich Raumtemperatur umfasst, dadurch gekennzeichnet, dass eine erste Beschichtungsstation vorgesehen ist, die zum einoder beidseitigen Auftragen eines vorzugsweise fotopolymerisierbaren, bei Raumtemperatur hochviskosen, schmelzbaren, niedermolekularen ersten Beschichtungsmittels mit einem mittleren Molekulargewicht von etwa 500-1500 ausgebildet ist, dass eine zweite Beschichtungsstation zum Auftragen eines hochmolekularen, vorzugsweise fotopolymerisierbaren, zweiten Beschichtungsmittels mit einem Molekulargewicht von etwa 2'000-10'000 über die erste Beschichtung vorgesehen ist, und dass die Temperiereinrichtung für die Leiterplattenoberfläche(n) vor der ersten Beschichtungsstation angeordnet ist bzw. Bestandteil der ersten Beschichtungsstation ist.

13. Vorrichtung nach Anspruch 12, dadurch gekennzeichnet, dass die erste Beschichtungsstation wenigstens eine Vorhanggussbeschichtungseinrichtung aufweist, welche einen Vorratsbehälter für die Lackschmelze sowie ein damit in Verbindung stehendes, in Transportrichtung der Leiterplatten schräg nach unten geneigtes und kurz oberhalb der Leiterplattentransportebene endendes, vorzugsweise beheizbares Ablaufblech bzw. eine vorzugsweise beheizbare Rakel sowie darüber angeordnete Heizeinrichtungen umfasst, mit deren Hilfe das über das Giessblech bzw. die Rakel ablaufende erste Beschichtungsmittel erst unmittelbar vor dem Auftragen auf die Leiterplattenoberfläche auf Giesstemperatur und Giessviskosität bringbar ist.

14. Vorrichtung nach Anspruch 13, dadurch gekennzeichnet, dass der Vorratsbehälter eine äussere und eine innere Kammer aufweist, die in der Nähe des Behälterbodens miteinander kommunizieren, wobei die äussere Kammer mit einer Versorgungsleitung für das geschmolzene erste Beschichtungsmittel verbunden ist und die innere Kammer, vorzugsweise an der tiefsten Stelle ihres Bodens, einen Auslass für das geschmolzene erste Beschichtungsmittel aufweist, wobei der Auslass der inneren Kammer tiefer angeordnet ist als die Mündung der Versorgungsleitung in der äusseren Kammer und im Betrieb vollständig von dem geschmolzenen ersten Beschichtungsmittel bedeckt ist.

15. Vorrichtung nach Anspruch 12, dadurch gekennzeichnet, dass die erste Beschichtungsstation als Walzenbeschichtungsanlage ausgebildet ist.

16. Vorrichtung nach Anspruch 15, dadurch gekennzeichnet, dass die Walzenbeschichtungsanlage zwei einander gegenüberliegende, vorzugsweise gummierte, beheizbare Auftragswalzen umfasst, zwischen denen ein einstellbarer Durchtrittsspalt von vorzugsweise etwa 50%-95% der Leiterplattendicke freigehalten ist, und welche von einem beheizbaren Schmelzenvorratstopf mit geschmolzenem erstem Beschichtungsmittel versorgt werden.

17. Vorrichtung nach einem der Ansprüche 12-16, dadurch gekennzeichnet, dass die zweite Beschichtungsanlage eine Walzenbeschichtungsanlage oder eine Sprühbeschichtungsanlage oder eine Laminierstation oder eine Siebdruck-Beschichtungsstation oder eine Vorhanggussbeschichtungsanlage zum ein- oder beidseitigen Auftragen des zweiten Beschichtungsmittels umfasst.

18. Verwendung des Verfahrens nach einem der Ansprüche 9-11 zur Herstellung einer Lötstoppmaske.

19. Verwendung des Verfahrens nach einem der Ansprüche 9-11 zur Herstellung einer Maske für die Erstellung hoher Lötdepots.

20. Verwendung des Verfahrens nach einem der Ansprüche 9-11 zur Herstellung eines Ätz- bzw. Galvanoresists.

21. Verwendung des Verfahrens nach einem der Ansprüche 9-11 zur Herstellung eines Permanentresists für Additivverfahren.

## Claims

1. A process for coating printed circuit boards with a coating that is crosslinkable by electromagnetic radiation, especially UV radiation, wherein:
- the printed circuit boards on the coating side are kept at room temperature and, as appropriate, are heated to approximately 120°C; and then
- in a first step, a preferably photopolymerisable, meltable, low-molecular-weight coating composition that has an average molecular weight of approximately from 500 to 1500 and that is highly viscous to solid at room temperature is coated in a thickness of approximately from 10 µm to 200 µm on to the surface(s) of the printed circuit board to be coated;
- in a second step, a second, high-molecular-weight, photopolymerisable coating composition having an average molecular weight of approximately from 2000 to 10 000 is applied in a thickness of from 2 µm to 20 µm over the first layer; and
- the printed circuit boards so coated are cooled to room temperature and the two-layer photopolymerisable coating is exposed, preferably in contact with a mask, is developed and is cured fully.

2. A process according to claim 1, wherein the first coating composition is coated at a temperature of approximately from 60°C to 120°C on to the surface of the printed circuit board.

3. A process according to either claim 1 or claim 2, wherein the printed circuit boards are coated on both sides prior to application of the second coating composition.

4. A process according to any one of the preceding claims, wherein the first coating composition is applied using the curtain pouring process, its pouring viscosity on coming into contact with the surface of the printed circuit board being approximately from 100 mPas to 500 mPas.

5. A process according to claim 4, wherein the first coating composition is poured or otherwise applied from a storage container on to a preferably heatable run-off plate or a heatable knife that extends obliquely downwards in the direction of transport of the printed circuit boards and ends just above the transport plane of the printed circuit boards, and is brought to pouring temperature and pouring viscosity by means of heating devices arranged above the pouring plate or the knife only immediately before it is coated on to the surface of the printed circuit boards.

6. A process according to any one of claims 1 to 3, wherein the first coating composition is coated on to the surface(s) of the printed circuit boards using the roll coating process.

7. A process according to claim 6, wherein the application viscosity of the first coating composition is approximately from 1000 mPas to 20 000 mPas, preferably approximately from 8000 mPas to 12 000 mPas, and the temperature of the surface of the printed circuit board to be coated is higher than the temperature of the first coating composition applied by means of the roll coating apparatus.

8. A process according to either claim 6 or claim 7, wherein the first coating composition is applied simultaneously to both surfaces of the printed circuit board.

9. A process according to any one of the preceding claims, wherein the second, high-molecular-weight coating composition is applied using the curtain pouring process, by roll coating, by spraying, by lamination or by means of screen printing.

10. A process according to claim 9, wherein the second coating composition comprises approximately from 20 to 70 % by weight fillers having an average particle size of from 5 µm to 20 µm.

11. A process according to either claim 9 or claim 10, wherein the second coating composition is applied to both surfaces of the printed circuit board, the two surfaces preferably being coated at the same time.

12. An apparatus for applying a coating that is crosslinkable by electromagnetic radiation, especially UV radiation, to the surface(s) of printed circuit boards, which comprises along a conveyor belt for the printed circuit boards at least one coating station for applying the coating to the surface(s) of the printed circuit boards, and a device for adjusting the temperature of the surface(s) of the printed circuit boards to a temperature that is preferably greater than or equal to room temperature, wherein there is provided a first coating station that is arranged for the one- or two-sided application of a preferably photopolymerisable, meltable, low-molecular-weight first coating composition that has an average molecular weight of approximately from 500 to 1500 and that is highly viscous at room temperature, wherein a second coating station is provided for the application, over the first coating, of a high-molecular-weight, preferably photopolymerisable, second coating composition having a molecular weight of approximately from 2000 to 10 000, and wherein the temperature-control device for the surface(s) of the printed circuit boards is arranged upstream of the first coating station or forms part of the first coating station.

13. An apparatus according to claim 12, wherein the first coating station has at least one curtain pouring coating device that comprises a storage container for the molten coating composition and a preferably heatable run-off plate or a preferably heatable knife that is connected to the storage container, extends obliquely downwards in the direction of transport of the printed circuit boards and ends just above the transport plane of the printed circuit boards, as well as heating devices, arranged above the run-off plate or the knife, by means of which the first coating composition flowing over the pouring plate or the knife can be brought to pouring temperature and pouring viscosity only immediately before it is coated on to the surface of the printed circuit boards.

14. An apparatus according to claim 13, wherein the storage container has an outer and an inner chamber which communicate with each other in the vicinity of the base of the container, the outer chamber being connected to a supply pipe for the molten first coating composition and the inner chamber having an outlet for the molten first coating composition, preferably at the lowermost point of its base, the outlet of the inner chamber being arranged at a lower level than the opening of the supply pipe into the outer chamber and being completely covered by the molten first coating composition during operation.

15. An apparatus according to claim 12, wherein the first coating station is in the form of a roll coating apparatus.

16. An apparatus according to claim 15, wherein the roll coating apparatus comprises two heatable, preferably rubberised, applicator rolls located opposite each other, between which there is an adjustable gap of preferably approximately from 50 % to 95 % of the thickness of the printed circuit boards, and which are supplied with molten first coating composition from a heatable molten composition storage vessel.

17. An apparatus according to any one of claims 12 to 16, wherein the second coating apparatus is a roll coating apparatus or a spray coating apparatus or a laminating station or a screen printing coating station or a curtain pouring coating station for the one- or two-sided application of the second coating composition.

18. The use of the process according to any one of claims 9 to 11 for the production of a solder mask.

19. The use of the process according to any one of claims 9 to 11 for the production of a mask for producing high solder deposits.

20. The use of the process according to any one of claims 9 to 11 for the production of an etching or electro resist.

21. The use of the process according to any one of claims 9 to 11 for the production of a permanent resist for additive processes.

## Revendications

1. Procédé de revêtement de circuits imprimés au moyen d'un revêtement réticulable par un rayonnement électromagnétique, de préférence un rayonnement ultraviolet, caractérisé en ce que :
- les circuits imprimés sont maintenue, du côté du revêtement , à la température ambiante et, le cas échéant, sont réchauffés à une température d'environ 120 °C.
- au cours d'une première étape, on dépose sur la ou les surfaces du circuit imprimé à revêtir un produit de revêtement de faible poids moléculaire, fusible, hautement visqueux à solide à la température ambiante, de préférence photopolymérisable, ayant un poids moléculaire moyen de 500 à 1500 environ et une épaisseur de 10 µm à 200 µm environ ;
- au cours d'une deuxième étape, on dépose sur cette première couche un deuxième produit de revêtement de poids moléculaire élevé photopolymérisable ayant un poids moléculaire moyen de 2000 à 10000 environ et une épaisseur de 2 µm à 20 µm ; et
- les circuits imprimés ainsi revêtus sont refroidis à la température ambiante et le revêtement bicouche photopolymérisable est de préférence insolé en contact avec un masque, développé et durci.

2. Procédé selon la revendication 1, caractérisé en ce que le premier produit de revêtement est déposé sur la surface du circuit imprimé à une température de 60 °C à 120 °C environ.

3. Procédé selon la revendication 1 ou la revendication 2, caractérisé en ce que les circuits imprimés sont revêtus sur leurs deux faces avant l'application du deuxième produit de revêtement.

4. Procédé selon l'une quelconque des revendications précédentes, caractérisé en ce que le premier produit de revêtement est déposé par couchage par voile, sa viscosité de couchage à l'arrivée sur la surface du circuit imprimé étant de 100 mPa·s à 500 mPa·s environ.

5. Procédé selon la revendication 4, caractérisé en ce que le premier produit de revêtement est coulé ou déposé d'une quelconque autre manière à partir d'un récipient d'alimentation sur une tôle d'écoulement, de préférence chauffante, inclinée obliquement vers le bas dans le sens de passage des circuits imprimés et se terminant un peu au-dessus du plan de transport des circuits imprimés ou bien sur une racle chauffante, et en ce qu'il est porté à la température et à la viscosité nécessaires pour le couchage, au moyen de dispositifs de chauffage disposés au-dessus de la tôle d'écoulement ou de la racle, juste avant d'être déposé sur la surface des circuits imprimés.

6. Procédé selon l'une des revendications 1 à 3, caractérisé en ce que le premier produit de revêtement est déposé sur la ou les surfaces des circuits imprimés selon le procédé de couchage au rouleau.

7. Procédé selon la revendication 6, caractérisé en ce que la viscosité de dépôt du premier produit de revêtement est de 1000 mPa·s à 20000 mPa·s environ, de préférence de 8000 mPa·s à 12000 mPa·s environ, et en ce que la surface des circuits imprimés à revêtir présente une température supérieure à celle du premier produit de revêtement déposé au moyen de l'installation de couchage au rouleau.

8. Procédé selon la revendication 6 ou la revendication 7, caractérisé en ce que le premier produit de revêtement est déposé simultanément sur les deux surfaces des circuits imprimés.

9. Procédé selon l'une quelconque des revendications précédentes, caractérisé en ce que le deuxième produit de revêtement de haut poids moléculaire est déposé par couchage par voile, par dépôt au rouleau, par pulvérisation, par stratification ou par sérigraphie.

10. Procédé selon la revendication 9, caractérisé en ce que le deuxième produit de revêtement contient une proportion de 20 à 70 % en poids de matières de charge ayant une granulométrie moyenne de 5 µm à 20 µm.

11. Procédé selon la revendication 9 ou la revendication 10, caractérisé en ce que le deuxième produit de revêtement est déposé sur les deux surfaces des circuits imprimés, les deux surfaces étant de préférence revêtues simultanément.

12. Dispositif de dépôt d'un revêtement réticulable par un rayonnement électromagnétique, de préférence un rayonnement ultraviolet, sur la ou les surfaces de circuits imprimés, -comprenant au moins, le long du trajet de transport des circuits imprimés, un poste de revêtement servant à déposer le revêtement sur la ou les surfaces des circuits imprimés et un dispositif de conditionnement de la ou des surfaces des circuits imprimés à une température de préférence supérieure ou égale à la température ambiante, caractérisé en ce qu'il est prévu un premier poste de revêtement pour le dépôt simple face ou double face d'un premier produit de revêtement de faible poids moléculaire, fusible, hautement visqueux à la température ambiante et de préférence photopolymérisable, ayant un poids moléculaire moyen de 500 à 1500 environ, en ce qu'il est prévu un deuxième poste pour déposer sur le premier revêtement un deuxième produit de revêtement de haut poids moléculaire, de préférence photopolymérisable, ayant un poids moléculaire moyen de 2000 à 10000 environ, et en ce que le dispositif de conditionnement de température de la ou des surfaces des circuits imprimés est disposé en amont du premier poste de revêtement ou bien fait partie intégrante dudit premier poste de revêtement.

13. Dispositif selon la revendication 12, caractérisé en ce que le premier poste de revêtement comprend au moins un dispositif de revêtement par couchage par voile qui se compose d'une cuve d'alimentation pour le vernis en fusion et, reliée à ladite cuve, d'une tôle d'écoulement, de préférence chauffante, inclinée obliquement vers le bas dans le sens de passage des circuits imprimés et se terminant un peu au-dessus du plan de transport des circuits imprimés ou bien d'une racle chauffante, ainsi que de dispositifs de chauffage disposés au-dessus de ladite tôle ou racle et grâce auxquels le premier produit de revêtement qui s'écoule par-dessus la tôle d'écoulement ou la racle peut être amené à la température et la viscosité nécessaires pour le couchage juste avant son dépôt sur la surface des circuits imprimés.

14. Dispositif selon la revendication 13, caractérisé en ce que la cuve d'alimentation comprend un compartiment extérieur et un compartiment intérieur qui communiquent entre eux au voisinage du fond de la cuve, le compartiment extérieur étant relié à une conduite d'alimentation pour le premier produit de revêtement en fusion et le compartiment intérieur étant relié, de préférence au point le plus bas de son fond, à une sortie pour le premier produit de revêtement en fusion, ladite sortie du compartiment intérieur étant disposée plus bas que l'orifice de la conduite d'alimentation débouchant dans le compartiment extérieur et, en fonctionnement, entièrement recouverte par le premier produit de revêtement en fusion.

15. Dispositif selon la revendication 12, caractérisé en ce que le premier poste de revêtement se présente sous la forme d'une installation de couchage au rouleau.

16. Dispositif selon la revendication 15, caractérisé en ce que l'installation de couchage au rouleau comprend deux rouleaux applicateurs chauffants, de préférence caoutchoutés, disposés l'un en face de l'autre, entre lesquels est ménagé un entrefer de passage réglable de préférence compris entre 50 % et 95 % environ de l'épaisseur des circuits imprimés et qui sont alimentés avec le premier produit de revêtement en fusion à partir d'un pot chauffant servant à alimenter la matière en fusion.

17. Dispositif selon l'une quelconque des revendications 12 à 16, caractérisé en ce que la deuxième installation de revêtement comprend une installation de couchage au rouleau, une installation de couchage par pulvérisation, un poste de stratification, un poste de revêtement par sérigraphie ou une installation de couchage par voile destiné(e) au dépôt simple face ou double face du deuxième produit de revêtement.

18. Utilisation du procédé selon l'une quelconque des revendications 9 à 11 pour réaliser un masque d'épargne de soudure.

19. Utilisation du procédé selon l'une quelconque des revendications 9 à 11 pour réaliser un masque servant à produire un dépôt de soudure.

20. Utilisation du procédé selon l'une quelconque des revendications 9 à 11 pour réaliser un résist de gravure ou de galvano.

21. Utilisation du procédé selon l'une quelconque des revendications 9 à 11 pour réaliser un résist permanent pour des procédés additifs.
